# EUROPEAN PATENT SPECIFICATION

(11) **EP 1 376 709 B1**
(45) Date of publication and mention of the grant of the patent: **24.01.2007**
(21) Application number: 02405496.7
(22) Date of filing: 17.06.2002
(51) Int. Cl.: H01L 39/16

(54) **Superconducting fault current limiter**
Supraleitender Fehlerstrombegrenzer
Limiteur de courant de défaut supraconducteur

(43) Date of publication of application: 02.01.2004
(73) Proprietor: ABB RESEARCH LTD., 8050 Zürich (CH)
(72) Inventor: Chen, Makan, 5102 Rupperswil (CH); Donzel, Lise, 5430 Wettingen (CH); Lakner, Martin, 5413 Birmenstorf (CH); Paul, Willi, 8006 Zürich (CH)
(74) Representative: ABB Patent Attorneys

(56) References cited:
- WO-A-00/10176
- DE-A- 19 750 758
- DE-A- 19 929 277
- DE-A- 19 958 727
- DE-C- 19 856 607

## Description

### FIELD OF THE INVENTION

The invention relates to the field of high-temperature superconductors. It is based on a superconducting fault current limiter according to the preamble of claim 1.

### BACKGROUND OF THE INVENTION

German Laid-Open Specification DE 196 34 424 A1 discloses a high-temperature superconductor arrangement for use in a current limiter. The arrangement comprises a superconductor layer, a silver layer in the form of an electrical bypass and which, together with the superconductor layer, forms a conductor composite, and a fiber composite layer. The latter contains a matrix composed of epoxy resin and glass or carbon fibers as a reinforcing base material. It is used to make the conductor composite mechanically robust and is applied by vacuum impregnation onto at least one main surface of the conductor composite.

Current limiters based on high-temperature superconductors are immersed in a cooling medium, preferably liquid nitrogen LN₂. If the superconductor undergoes a passive transition to the resistive state in the case of an overcurrent resulting from a short circuit, energy is generated in the conductor composite and the latter is heated very severely and requires a certain amount of time to cool down to the operating temperature again. The resistive heat produced during the fault event, therefore has to be dissipated as efficiently as possible, i.e. conducted toward the liquid nitrogen at right angles to the conductor composite layer. In a superconductor arrangement as mentioned above, the efficiency of the heat transfer to the liquid nitrogen LN₂ is reduced, however, as soon as a gaseous film is formed on the surface of the superconductor arrangement, since the specific heat of nitrogen gas is lower than the latent heat of vaporisation of LN₂.

In the German Laid-Open Specification DE 199 29 277 A1, a high-temperature superconductor arrangement is provided in which the superconductor is protected against excessive heating following a short circuit. This is achieved by providing a heat-storage layer in contact with the superconductor which absorbs the heat produced by a short-term overcurrent in the superconductor, and later emits it to the cooling medium. In consequence, the superconductor is not heated adiabatically, but to a lower maximum temperature, and cools down again to its critical temperature correspondingly more rapidly. According to a preferred embodiment, the heat storage layer is formed from a fiber composite material layer which has added to it a filling material with a high specific heat, in order to increase the heat capacity. This filling material is added to the polymer matrix and passes through the base fabric of the composite material.

It has been observed that the heat storage layer mentioned above in fact does accelerate the cooling of the conductor composite down to the critical temperature following a fault event. However, at the interface between the superconductor arrangement and the cooling medium, liquid nitrogen LN₂ is vaporised and shock or pressure waves are created. The latter impact on any superconductor components immersed in the same volume of liquid nitrogen. Considerable mechanical stresses, often in combination with additional thermal stresses, are exerted on these superconducting components and may cause the latter to fail mechanically.

The document DE 19750758 relates to a high temperature superconductor grown on a substrate and covered by a shunt layer. Both the substrate and the shunt layer are covered by a heat insulating surface layer that is in contact with liquid nitrogen as a coolant. The heat insulating layer comprises e.g. a lacquer, epoxy resin or Teflon, and serves the admittedly unexpected purpose of decreasing the recovery time, i.e. it helps the superconductor to cool back to the temperature of the coolant more rapidly.

### DESCRIPTION OF THE INVENTION

It is therefore an object of the invention to create a superconducting fault current limiter of the type mentioned initially, which is less exposed to mechanical stresses in the case of a fault current in a line comprising the superconductor arrangement. This object is achieved by a superconducting fault current limiter according to patent claim 1. Preferred embodiments are evident from the dependent patent claims.

In the inventive high-temperature superconducting fault current limiter, an electrically non-conducting thermal barrier is provided adjacent to a conductor composite. The joule heat generated in the conductor composite during a fault current event is prevented from being conducted instantly to a liquid nitrogen reservoir. Said heat is slowly released to the cooling liquid well after the fault event began. The time for cooling to the operational temperature is thus increased, preferably by at least a factor of two, with respect to a similar arrangement without thermal barrier. Less violent shock or pressure waves in the surrounding cooling fluid following a fault current event are created, and film boiling is practically absent.

The underlying physical quantity determining the heat transfer across the thermal barrier is the ratio of the thermal conductivity and the thickness of the barrier. Preferably, said ratio should be between 50 and 1000 W/m²K. On the other hand, geometrical considerations define an upper limit to the total thickness of a module comprising two band shaped conductor composites being arranged back to back, leading to maximum thickness of the thermal barriers of about 2 mm.

In a preferred variant of the invention, the thermal barrier comprises a bulk body made of a porous material such as cork or pressboard or wool felt, which is glued to the conducter composite by means of an adhesive.

Of particular interest as a material for the thermal barrier is a layer of pressboard, i.e. compressed cellulose, preferably at least partially impregnated by a thermosetting polymer such as an epoxy resin. An impregnated pressboard is mechanically favourable due to its low elastic module and the excellent match of its thermal expansion coefficient with those of the conductor composite.

### BRIEF DESCRIPTION OF THE DRAWINGS

The subject matter of the invention will be explained in more detail in the following text with reference to preferred exemplary embodiments which are illustrated in the attached drawings, in which:
- Fig. 1: schematically shows a cross section through a superconductor arrangement extending perpendicularly to the plane of the cross section,
- Fig.2: shows the dependence of the recovery time t_{rec} on the thickness d of the thermal barrier, and
- Fig.3: shows the dependence of the recovery time t_{rec} on the amount of energy E deposited per unit surface of the arrangement.

The reference symbols used in the drawings, and their meanings, are listed in summary form in the list of reference symbols. In principle, identical parts are provided with the same reference symbols in the figures.

### DETAILED DESCRIPTION OF PREFERRED EMBODIMENTS

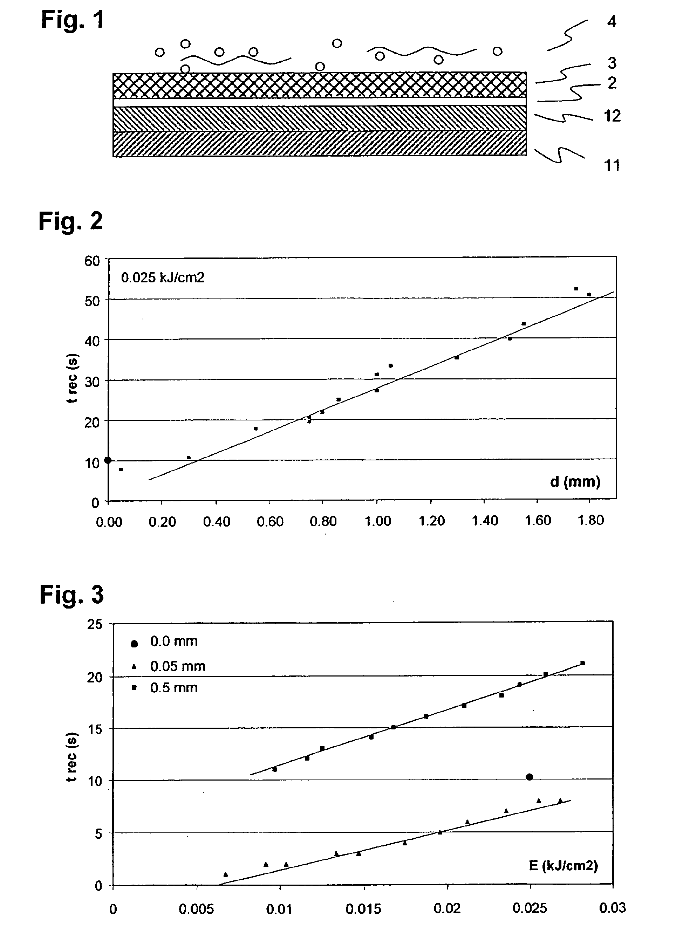

Fig.1 shows a planar superconductor arrangement to be used in a fault current limiter according to the invention, having a conductor composite 1 comprising a superconducting layer 11 and a normal conducting electrical bypass layer 12. A thermal barrier layer 3 is in contact with both a main surface of the conductor composite 1 and a cooling fluid 4. In this exemplary embodiment, the thermal barrier layer 3 is arranged on the bypass side of the conductor composite 1 and attached to the latter by means of an adhesive layer 2 ensuring at the same time a heat transfer between the conductor composite 1 and the thermal barrier 3. A major part of the heat dissipated during short-term overloading of the conductor composite 1 is temporarily buffered in the composite 1 and the thermal barrier 3. Said heat is released to the coolant 4 after a few alternating-current cycles, i.e. typically after the short circuit ends. Correspondingly, the conductor composite requires more time to cool down again to the operating temperature, but due to the smooth heat transfer process, no shock waves are created in a surrounding cooling fluid 4.

Typical dimensions for the arrangement are layer thicknesses of 0.5 mm for both a Bi-based polycrystalline superconductor layer 11 and a steel bypass layer 12. The width of a composite conductor band or track in the form of a meander for current limiting purposes is about 2 cm. The composite conductor 1 may be attached to a substrate or a further layer with a higher thermal resistance than the thermal barrier layer 3. Alternatively, a first arrangement of this type may be combined in a back to back manner with a second arrangement to form a so-called module, as is discussed extensively in the aforementioned document DE 196 34 424 A1. Any number of modules can further be arranged and interconnected in the form of a stack to provide for a sufficient conductor length. In such stacks, the electrical insulation between neighbouring conductors is only a minor concern, as the voltage difference between two points is proportional to the conductor length in between, and therefore amounts to only a fraction of the total voltage applied to the current limiter in case of a fault. However, in order to make efficient use of the space available in a cooling container, the total thickness of a module, and hence the thickness of the two thermal barrier layers encapsulating it, is limited. Furthermore, as a coverage of 70% of the surface of the conductor composite 1 is expected to lead to a sufficient reduction in gaseous N₂ being formed at the interface between the cooling medium 4 and the superconductor arrangement, the conductor composite 1 is not required to be covered in its entirety by the thermal barrier layer 3.

In superconductor arrangements as mentioned above, the heat transfer density γ through the composite to the surrounding coolant, averaged during the recovery process, is required to be as little as 2 W/cm². Assuming an averaged temperature difference ΔT across the thermal barrier of a few ten K, the ratio ΔT, which equals the ratio of the thermal conductivity κ and a thickness d_{tb} of the thermal barrier, amounts to 50 to 1000 W/m²K. However, if larger temperature differences ΔT are to expected, either as average or peak values, the aforementioned ratio might be chosen correspondingly smaller.

Fig.2 is a graph showing the recovery time t_{rec} as a function of the thickness d of the thermal barrier. The recovery time t_{rec} is the time needed for the superconductor 11, following a fault event, to return to its operating temperature, which generally is the temperature of the surrounding liquid coolant. Hence, the recovery time t_{rec} is conveniently determined by observing the time until no more bubbles are formed in the liquid coolant.. At zero thermal barrier, i.e. with the bypass layer in direct contact with the coolant, the recovery process takes 10 seconds (heavy dot at 0.0 mm), whereas with a layer of cured epoxy resin as suggested in DE 199 29 277 A1 (second point from the left, at d=0.05 mm) the recovery time t_{rec} is reduced to 7 seconds. In both these cases, mechanical damage has been observed in the superconducting components.

The recovery time could be increased and the mechanical damage reduced by means of a thermal barrier in the form of a bulk body or matrix with open pores. The wording "bulk" in this context refers to a barrier consisting of more than just one layer of cloth, i.e. woven or textured fibers. The bulk bodies are preferably impregnated with a low-viscosity polymer resin, closing at least partially the open pores. In Fig.2, the recovery times t_{rec} for impregnated pressboards of various thicknesses d are listed. Similar results were obtained with cork sheets of comparable thicknesses. Alternatively, layers of wool felt and rubber foam were also tested with success. Being simply glued to the conductor composite and/or only partially impregnated, said layers of wool felt or rubber foam essentially retain an open pore structure. By trapping the N₂ bubbles formed in the interior of these pores, the cooling liquid LN₂ is prevented from entering into contact with the conductor composite, and an additional delay of the heat transfer is achieved.

Fig.3 shows the dependence of the recovery times t_{rec} on the amount of energy E generated per surface area of the composite, i.e. the dissipated power per surface area integrated over the duration of the fault event. As already depicted in Fig.2, without thermal barrier, t_{rec} equals 10 seconds (heavy dot at E=25 J/cm², "0.0mm"). With a thin layer of cured epoxy resin of 0.05 mm thickness (triangles, "0.05mm") the recovery time t_{rec} goes down whereas for an impregnated pressboard layer of 0.5 mm thickness (squares, "0.5mm"), the recovery time for all energies investigated goes up.

Pressboards, i.e. compressed boards produced from cellulose can be impregnated with low-viscosity polymer resins using appropriate processes, resulting in a pressboard - polymer matrix composite. Suitable resin systems are based, for example, on epoxy, silicon or polyester resins. Such resins can alternatively or at the same time be used as the adhesive 2 for bonding the thermal barrier 3 to the composite 1. By doing so, the polymer resin layer 2 additionally prevents the cooling liquid 4 from penetrating between the aforementioned layers.

In the range between room temperature and the operating temperature, the mean thermal coefficient of expansion of the pressboard - polymer matrix composite is comparable to that of the conductor composite (10-15 x 10⁻⁶/K). This results in the possibility of bringing the cellulose composite and the conductor composite into direct and permanent mechanical contact without any need to be concerned about damage induced by stresses during cooling or heating.

### LIST OF DESIGNATIONS

- 1: conductor composite
- 11: superconductor
- 12: electrical bypass
- 2: adhesive
- 3: thermal barrier
- 4: cooling fluid

## Claims

1. A superconducting fault current limiter, comprising
a band-shaped conductor composite (1) with a first and a second main surface, including a superconductor layer (11) made of a high-temperature superconductor material and an electrical bypass layer (12), and
an electrically non-conducting thermal barrier layer (3) in contact with the first main surface of the conductor composite (1), and arranged on the first main surface so that it can be brought into contact with a cooling fluid,
**characterized in that** the thermal barrier layer (3) has thermal properties which increase a recovery time t_{rec} needed for the conductor composite (1) to cool below a critical temperature T_{c} of the superconductor (11) following a fault event, as compared to an identical conductor composite without any thermal barrier layer,
and **in that** the thickness of the thermal barrier layer (3) is between about 0.3 and 2 mm.

2. The fault current limiter as claimed in claim 1, **characterised in that** the ratio of a thermal conductivity κ and a thickness d_{tb} of the thermal barrier layer (3) is between 50 and 1000 W/m²K.

3. The fault current limiter as claimed in claim 1, **characterised in that** the thermal barrier layer (3) comprises a bulk body made of a porous material.

4. The fault current limiter as claimed in claim 3, **characterised in that** the thermal barrier layer (3) comprises a pressboard at least partially impregnated by a polymer resin.

## Patentansprüche

1. Supraleitender Fehlerstrombegrenzer, der folgendes umfaßt:
ein bandförmiges Leiterverbundmaterial (1) mit einer ersten und einer zweiten Hauptoberfläche, mit einer Supraleiterschicht (11) aus einem Hochtemperatursupraleitermaterial und einer elektrischen Umgehungsschicht (12), und
einer elektrisch nichtleitenden Wärmebarrierenschicht (3) in Kontakt mit der ersten Hauptoberfläche des Leiterverbundmaterials (1) und angeordnet auf der ersten Hauptoberfläche derart, daß sie in Kontakt mit einem Kühlfluid gebracht werden kann,
**dadurch gekennzeichnet, daß** die Wärmebarrierenschicht (3) Wärmeeigenschaften aufweist, die eine Erholungszeit t_{rec} heraufsetzen, die erforderlich ist, damit sich das Leiterverbundmaterial (1) nach einem Fehlerereignis unter eine kritische Temperatur T_{C} des Supraleiters (11) abkühlt im Vergleich zu einem identischen Leiterverbundmaterial ohne irgendwelche Wärmebarrierenschicht,
und daß die Dicke der Wärmebarrierenschicht (3) zwischen etwa 0,3 und 2 mm liegt.

2. Fehlerstrombegrenzer nach Anspruch 1, **dadurch gekennzeichnet, daß** das Verhältnis aus Wärmeleitfähigkeit κ und eine Dicke d_{tb} der Wärmebarrierenschicht (3) zwischen 50 und 1000 W/m²K liegt.

3. Fehlerstrombegrenzer nach Anspruch 1, **dadurch gekennzeichnet, daß** die Wärmebarrierenschicht (3) einen aus einem porösen Material hergestellten Volumenkörper umfaßt.

4. Fehlerstrombegrenzer nach Anspruch 3, **dadurch gekennzeichnet, daß** die Wärmebarrierenschicht (3) eine zumindest teilweise mit einem Polymerharz impregnierte Presspappe umfaßt.

## Revendications

1. Limiteur de courant de défaut supraconducteur comprenant un composite conducteur (1) en forme de bande avec une première et une deuxième surfaces principales, comprenant une couche supraconductrice (11) constituée d'un matériau supraconducteur à haute température et d'une couche de dérivation électrique (12) et une couche barrière thermique (3) non conductrice d'électricité en contact avec la première surface principale du composite conducteur (1) et disposée sur la première surface principale de telle sorte qu'elle peut être mise en contact avec un fluide de refroidissement, **caractérisé en ce que** la couche barrière thermique (3) possède des propriétés thermiques qui augmentent un temps de rétablissement t_{rec} nécessaire au composite conducteur (1) pour refroidir au-dessous d'une température critique T_{c} du supraconducteur (11) consécutivement à une situation de défaut par rapport à un composite conducteur identique sans aucune couche barrière thermique et **en ce que** l'épaisseur de la couche barrière thermique (3) est comprise entre environ 0,3 et 2 mm.

2. Limiteur de courant de défaut selon la revendication 1, **caractérisé en ce que** le rapport entre une conductivité thermique k et une épaisseur d_{tb} de la couche barrière thermique (3) est compris entre 50 et 1000 W/m²K.

3. Limiteur de courant de défaut selon la revendication 1, **caractérisé en ce que** la couche barrière thermique (3) comprend un corps volumineux constitué d'un matériau poreux.

4. Limiteur de courant de défaut selon la revendication 3, **caractérisé en ce que** la couche barrière thermique (3) comprend un carton comprimé au moins partiellement imprégné d'une résine polymère.
